# EUROPEAN PATENT SPECIFICATION

(11) **EP 4 593 576 B1**
(45) Date of publication and mention of the grant of the patent: **30.09.2026**
(21) Application number: 23867987.2
(22) Date of filing: 30.08.2023
(51) Int. Cl.: H10N 30/85, H10N 30/092, H04R 17/00

(54) **PIEZOELECTRIC COMPOSITE MATERIAL FILM**
PIEZOELEKTRISCHER KOMPOSITMATERIALFILM
FILM EN MATÉRIAU COMPOSITE PIÉZOÉLECTRIQUE

(30) Priority: 22.09.2022 JP 2022151443
(43) Date of publication of application: 30.07.2025
(73) Proprietor: FUJIFILM Corporation, Tokyo 106-8620 (JP)
(72) Inventor: TAMADA, Yoshinori, Minamiashigara-shi, Kanagawa 250-0193 (JP)
(74) Representative: Klunker IP Patentanwälte PartG mbB
(86) International application number: PCT/JP2023/031373
(87) International publication number: WO 2024/062863

(56) References cited:
- WO-A1-2016/006580
- WO-A1-2016/143469
- WO-A1-2021/157288
- WO-A1-2021/157288
- US-A1- 2020 301 525
- US-A1- 2022 384 706
- CRACIUN F ET AL: "Flexible composite films with enhanced piezoelectric properties for energy harvesting and wireless ultrasound-powered technology", COMPOSITES PART B, vol. 263, 110835, 8 June 2023 (2023-06-08), XP087355145, DOI: 10.1016/J.COMPOSITESB.2023.110835

## Description

### BACKGROUND OF THE INVENTION

### 1. Field of the Invention

The present invention relates to a piezoelectric film.

### 2. Description of the Related Art

With a reduction in thickness of displays such as liquid crystal displays or organic EL displays, speakers used in these thin displays are also required to be lighter and thinner. Furthermore, in a flexible display having flexibility, a speaker is also required to have flexibility in order to integrate the speaker into the flexible display without impairing lightness and flexibility. As such lightweight, thin, and flexible speakers, it is considered to employ sheet-like piezoelectric films (electroacoustic conversion films) having a property of stretch and contraction in response to an applied voltage.

As a sheet-like piezoelectric film, for example, a film formed of a material having piezoelectricity, such as polyvinylidene fluoride (PVDF), is known. In addition, the present applicant has proposed a piezoelectric film, which is a sheet-like piezoelectric film having flexibility and capable of stably reproducing a high quality sound, in which a polymer-based piezoelectric composite material obtained by dispersing piezoelectric particles in a matrix formed of a polymer material is used as a piezoelectric layer.

For example, WO 2021/157288 A1 describes a piezoelectric film including a polymer-based piezoelectric composite material that contains piezoelectric particles in a matrix containing a polymer material, and electrode layers provided on both surfaces of the polymer-based piezoelectric composite material, in which a cross section of the piezoelectric film in a thickness direction is observed with a scanning electron microscope, the polymer-based piezoelectric composite material is divided into 10 equal parts in the thickness direction, and in a case where an area ratio of the piezoelectric particles in two regions most spaced apart from each other is measured, and the area ratio of the piezoelectric particles in a region having a low area ratio is set to 1, the area ratio of the piezoelectric particles in a region having a high area ratio is 1.2 or more. US 2020/0301525 A1 discloses a similar composite piezoelectric material film, wherein the piezoelectric particles are substantially aligned within the polymeric matrix along a Z-axis corresponding with a thickness of the film.

### SUMMARY OF THE INVENTION

Such a piezoelectric film is required to further improve sound pressure.

An object of the present invention is to solve such a problem of the related art and to provide a piezoelectric film capable of further improving a sound pressure.

In order to solve the above-described problems, the present invention has the following configuration.
[1] A piezoelectric film comprising:
   a piezoelectric layer consisting of a polymer-based piezoelectric composite material which contains piezoelectric particles in a matrix containing a polymer material; and
   two electrode layers provided on both surfaces of the piezoelectric layer,
   in which in a case where a standard deviation in which a cross section of the piezoelectric layer in a thickness direction is observed with a scanning electron microscope, 10 regions each having the same width as a thickness of the cross section of the piezoelectric layer are continuously acquired, each of the regions is divided into 10 parts in an in-plane direction, and an area ratio of the piezoelectric particles in each of a total of 100 parts is calculated, is defined as an in-plane standard deviation, 1% ≤ in-plane standard deviation ≤ 3% is satisfied, and
   in a case where a standard deviation in which each of the regions is divided into 10 parts in the thickness direction and an area ratio of the piezoelectric particles in each of a total of 100 parts is calculated, is defined as a thickness standard deviation, 0.5% ≤ thickness standard deviation ≤ 2% is satisfied.
[2] The piezoelectric film according to [1],
   in which 1.7% ≤ in-plane standard deviation ≤ 2.8% and 0.6% ≤ thickness standard deviation ≤ 1.3% are satisfied.
[3] The piezoelectric film according to [1] or [2],
   in which an average value of the area ratios of the piezoelectric particles in each of the total of 100 parts is 40% to 90%.

According to the present invention, it is possible to provide a piezoelectric film capable of further improving a sound pressure.

### BRIEF DESCRIPTION OF THE DRAWINGS

Fig. 1 is a view schematically showing an example of a piezoelectric film according to the present invention.
Fig. 2 is a partially enlarged view of the piezoelectric film shown in Fig. 1.
Fig. 3 is a conceptual view for describing a method of obtaining an in-plane standard deviation.
Fig. 4 is a conceptual view for describing a method of obtaining a thickness standard deviation.
Fig. 5 is a conceptual view for describing an example of the method of preparing the piezoelectric film.
Fig. 6 is a conceptual view for describing an example of the method of preparing the piezoelectric film.
Fig. 7 is a conceptual view for describing an example of the method of preparing the piezoelectric film.
Fig. 8 is a conceptual view for describing an example of the method of preparing the piezoelectric film.
Fig. 9 is a graph in which the in-plane standard deviation and the thickness standard deviation of Examples and Comparative Examples are plotted.
Fig. 10 is a conceptual view for describing a piezoelectric film of the related art.
Fig. 11 is a conceptual view for describing another example of the piezoelectric film of the related art.

### DESCRIPTION OF THE PREFERRED EMBODIMENTS

Hereinafter, the piezoelectric film according to the embodiment of the present invention will be described in detail based on suitable embodiments shown in the accompanying drawings.

Although configuration requirements to be described below are described based on representative embodiments of the present invention, the present invention is not limited to the embodiments.

In the present specification, a numerical range expressed using "to" refers to a range including numerical values described before and after "to" as a lower limit value and an upper limit value.

### [Piezoelectric film]

A piezoelectric film according to the embodiment of the present invention is the piezoelectric film including
a piezoelectric layer consisting of a polymer-based piezoelectric composite material which contains piezoelectric particles in a matrix containing a polymer material, and
two electrode layers provided on both surfaces of the piezoelectric layer,
in which, in a case where a standard deviation in which a cross section of the piezoelectric layer in a thickness direction is observed with a scanning electron microscope, 10 regions each having the same width as a thickness of the cross section of the piezoelectric layer are continuously acquired, each of the regions is divided into 10 parts in an in-plane direction, and an area ratio of the piezoelectric particles in each of a total of 100 parts is calculated, is defined as an in-plane standard deviation, 1% ≤ in-plane standard deviation ≤ 3% is satisfied, and
in a case where a standard deviation in which each of the regions is divided into 10 parts in the thickness direction and an area ratio of the piezoelectric particles in each of a total of 100 parts is calculated, is defined as a thickness standard deviation, 0.5% ≤ thickness standard deviation ≤ 2% is satisfied.

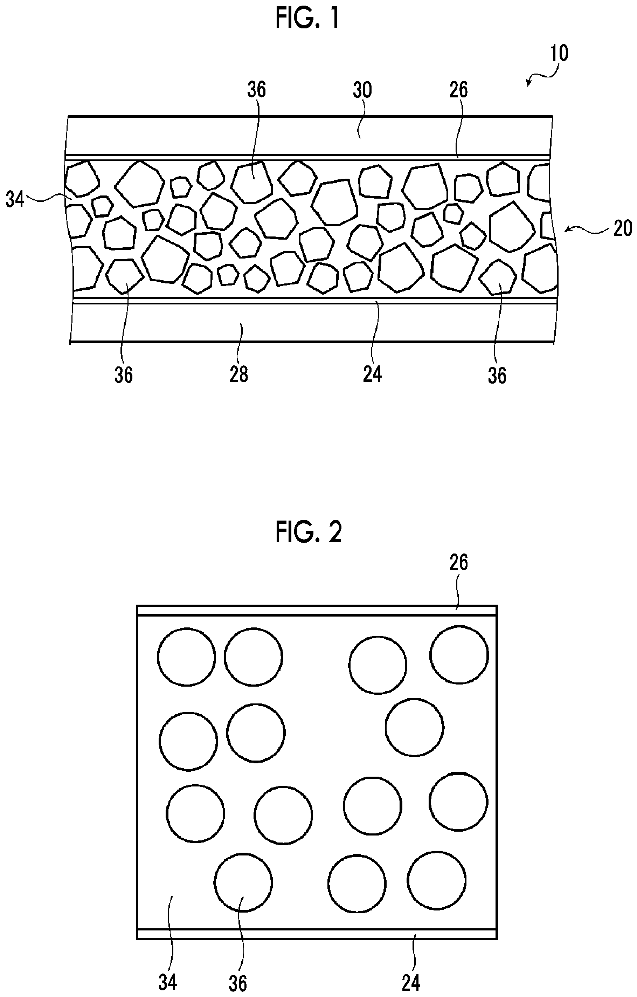

Fig. 1 is a view schematically showing an example of the piezoelectric film according to the embodiment of the present invention.

A piezoelectric film 10 shown in Fig. 1 includes a piezoelectric layer 20 which is a sheet-like material having piezoelectricity, a first electrode layer 24 laminated on one surface of the piezoelectric layer 20, a first protective layer 28 laminated on a surface of the first electrode layer 24 opposite to the piezoelectric layer 20, a second electrode layer 26 laminated on the other surface of the piezoelectric layer 20, and a second protective layer 30 laminated on a surface of the second electrode layer 26 opposite to the piezoelectric layer 20. That is, the piezoelectric film 10 has a configuration in which the piezoelectric layer 20 is sandwiched between the electrode layers and the protective layer is laminated on a surface of the electrode layer, which is not in contact with the piezoelectric layer.

The terms "first" and "second" in the first electrode layer 24 and the first protective layer 28, and in the second electrode layer 26 and the second protective layer 30 are added for convenience in order to describe the piezoelectric film 10. Therefore, the terms "first" and "second" in the present invention have no technical meanings and are irrelevant to the actual usage state.

In addition, the first protective layer 28 and the second protective layer 30 have the same essential configuration except that disposition positions thereof are different from each other. Accordingly, in the following description, in a case where it is not necessary to distinguish the first protective layer 28 from the second protective layer 30, both members are collectively referred to as a protective layer.

Similarly, the first electrode layer 24 and the second electrode layer 26 are essentially the same except that the positions are different from each other. Accordingly, in the following description, in a case where it is not necessary to distinguish the first electrode layer 24 and the second electrode layer 26, both members are collectively referred to as an electrode layer.

In the present invention, the piezoelectric layer 20 is a polymer-based piezoelectric composite material containing piezoelectric particles 36 in a matrix 34 containing a polymer material, as conceptually shown in Fig. 1. The piezoelectric particles 36 are piezoelectric bodies having piezoelectricity of stretching and contracting according to an applied voltage. The piezoelectric layer 20 has flexibility and piezoelectricity by dispersing the piezoelectric particles 36 in the matrix 34.

In the piezoelectric film 10, the piezoelectric layer 20 is stretched and contracted to be driven as a piezoelectric material by applying a voltage to the first electrode layer 24 and the second electrode layer 26. In a case where the piezoelectric film 10 is driven, the piezoelectric film 10 stretches and contracts in the in-plane direction, and as a result, the piezoelectric film 10 vibrates in the thickness direction to generate a sound. The piezoelectric film 10 vibrates according to magnitude of the applied driving voltage and generates a sound according to the applied driving voltage.

Here, in the piezoelectric film according to the embodiment of the present invention, in a case where a cross section of the piezoelectric layer 20 in a thickness direction is observed with a scanning electron microscope (SEM), 10 regions having the same width as a thickness of the cross section of the piezoelectric layer 20 are continuously acquired, each of the regions is divided into 10 parts in an in-plane direction, an area ratio of the piezoelectric particles 36 in each of a total of 100 parts is calculated, and a standard deviation of the area ratio of the piezoelectric particles 36 is defined as an in-plane standard deviation, 1% ≤ in-plane standard deviation ≤ 3% is satisfied, and in a case where each of the regions is divided into 10 parts in the thickness direction, an area ratio of the piezoelectric particles 36 in each of the total of 100 parts is calculated, and a standard deviation of the area ratio of the piezoelectric particles 36 is defined as a thickness standard deviation, 0.5% ≤ thickness standard deviation ≤ 2% is satisfied.

As conceptually shown in Fig. 2, the piezoelectric layer 20 satisfying ranges of the above-described in-plane standard deviation and thickness standard deviation has a state in which a presence state of the piezoelectric particles is not uniform and has a certain degree of unevenness in the in-plane direction.

As described above, in a case where a voltage is applied to the piezoelectric film 10, the piezoelectric layer 20 stretches and contracts in the in-plane direction to vibrate in the thickness direction, thereby generating a sound. That is, in order to improve a sound pressure, it is sufficient that the stretch and contraction of the piezoelectric layer 20 in the in-plane direction are increased. The stretch and contraction of the piezoelectric layer 20 is contributed by the stretch and contraction of the piezoelectric particles 36, and in order to increase the stretch and contraction of the piezoelectric particles 36, it is sufficient that a large voltage is applied to the piezoelectric particles 36 in a case where a certain voltage is applied to the piezoelectric film 10.

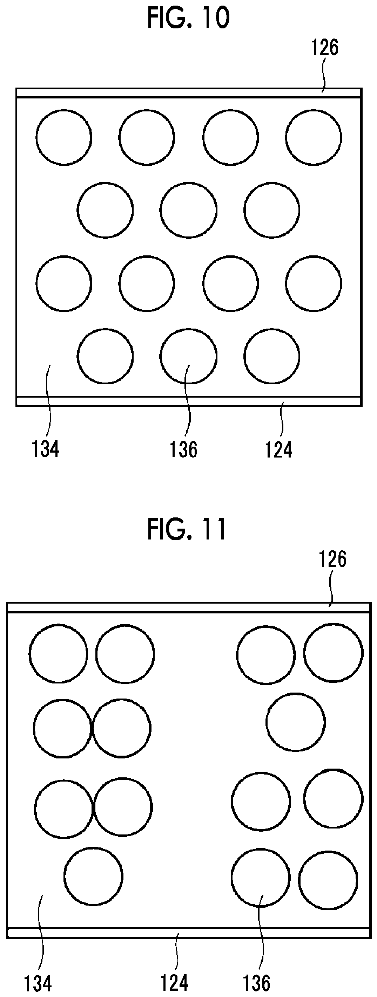

Here, according to studies of the present inventors, it was found that in order to apply a large voltage to the piezoelectric particles 36, it is preferable that the piezoelectric particles 36 are gathered (connected) in the thickness direction of the piezoelectric layer 20 as shown in Fig. 2 rather than piezoelectric particles 136 are uniformly present as in the piezoelectric film of the related art as shown in Fig. 10. In a case where the piezoelectric particles 36 are gathered in the thickness direction of the piezoelectric layer 20, the voltage applied to the piezoelectric particles 36 is increased, so that the stretch and contraction of the piezoelectric particles 36 can be increased.

On the other hand, as shown in Fig. 11, it was found that in a case where the piezoelectric particles 136 are excessively gathered in a film thickness direction to obtain a columnar shape, as shown in Fig. 11, a region in which an abundance ratio of the piezoelectric particles 136 is small in the in-plane direction is generated, and the stretch and contraction in the in-plane direction cannot be efficiently transmitted, so that the sound pressure is decreased.

Therefore, the present inventors have found that, by setting the in-plane standard deviation and the thickness standard deviation of the area ratio of the piezoelectric particles 36 in the piezoelectric layer 20 to be in the above-described ranges, the piezoelectric particles 36 in the piezoelectric layer 20 can be brought into a state of being gathered in the thickness direction in an appropriate range, and a linking property between the piezoelectric particles 36 in the in-plane direction can be prevented from being decreased while increasing the voltage applied to the piezoelectric particles 36, so that the stretch and contraction in the in-plane direction can be efficiently transmitted. In this manner, the piezoelectric film 10 according to the embodiment of the present invention can improve the sound pressure in a case where the same voltage is applied.

The in-plane standard deviation and the thickness standard deviation are obtained as follows.

First, the piezoelectric film is cut in the thickness direction in order to observe the cross section of the piezoelectric film. For example, it is sufficient that the piezoelectric film is cut by mounting a histo knife blade (manufactured by Drukker) having a width of 8 mm on RM2265 (manufactured by Leica Biosystems) and setting a speed to a controller scale of 1 and an engagement amount of 0.25 µm to 1 µm.

The cross section thereof is observed with a SEM (for example, SU8220, manufactured by Hitachi High-Technologies Corporation).

An example of the conditions for observation with a SEM is shown below.

The sample is subjected to a conductive treatment by Pt vapor deposition, and the work distance is set to 8 mm.

The observation is made under conditions of a secondary-electron (SE) image (Upper) and an acceleration voltage of 0.5 kV, the sharpest image is output by focus adjustment and astigmatism adjustment, and automatic brightness adjustment (auto setting, brightness: 0, contrast: 0) is carried out in a state where the piezoelectric film covers the entire screen.

The imaging magnification is set as the magnification such that the first electrode layer and the second electrode layer fit on one screen and the width between both electrode layers reaches a half or greater of the screen. Here, an image is captured such that two electrode layers are horizontal to the lower portion of the image.

10 continuous visual fields are captured at any position of any cross section of the piezoelectric layer with a SEM.

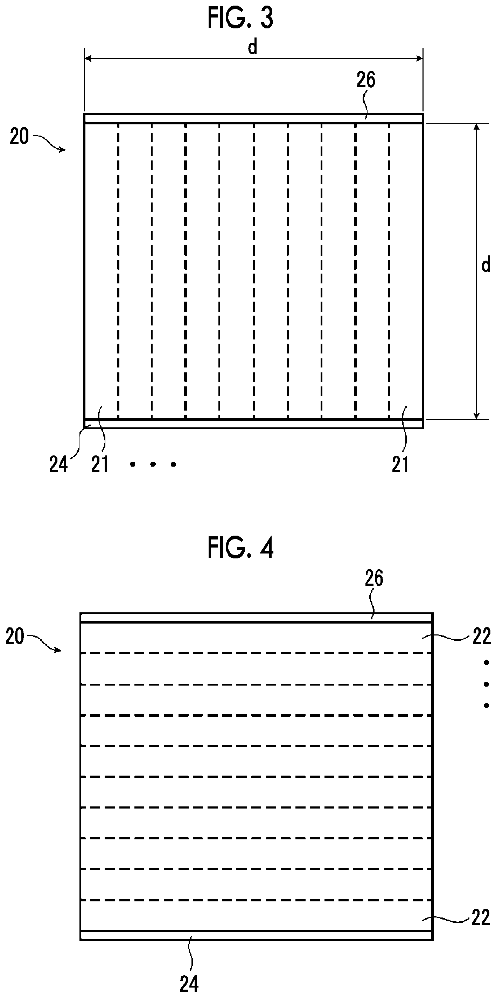

In the obtained SEM image, the thickness of the cross section of the piezoelectric layer is measured at intervals of 1 µm at 10 points or more, and the average value thereof is obtained. 10 continuous regions in the SEM image are acquired with the same width as the average value of the obtained thicknesses as one region. Each of the acquired 10 regions is divided into 10 parts in an in-plane direction as shown in Fig. 3, and an area ratio of the piezoelectric particles in one part 21 to a geometric area of the one part 21 is calculated in each of the total of 100 parts of the 10 regions. The standard deviation is calculated from the area ratio of the piezoelectric particles in a total of 100 parts, so that the in-plane standard deviation is obtained.

In addition, as shown in Fig. 4, each of the 10 regions acquired as described above is divided into 10 parts in the thickness direction, and the area ratio of the piezoelectric particles in one part 22 to the geometric area of the one part 22 is calculated in each of the total of 100 parts of the 10 regions. The standard deviation is calculated from the area ratio of the piezoelectric particles in the total of 100 parts, so that the thickness standard deviation is obtained.

Figs. 3 and 4 are diagrams conceptually showing one region of the piezoelectric layer 20, and a drawing of the piezoelectric particles is not shown.

From the viewpoint that the sound pressure can be further improved, the in-plane standard deviation preferably satisfies 1.7% ≤ in-plane standard deviation ≤ 2.8%, and more preferably satisfies 2.0% ≤ in-plane standard deviation ≤ 2.5%. In addition, the thickness standard deviation preferably satisfies 0.6% ≤ thickness standard deviation ≤ 1.3%, and more preferably satisfies 0.6% ≤ thickness standard deviation ≤ 1.0%.

The in-plane standard deviation and the thickness standard deviation of the area ratio of the piezoelectric particles in the piezoelectric layer 20 of the piezoelectric film 10 can be adjusted by a type and an amount ratio of a solvent in a coating material (composition) for forming the piezoelectric layer 20, a coating method of the coating material, a drying method of a coating film, a calender treatment for the coating film, and the like.

This point will be described below.

In addition, from the viewpoint that the sound pressure, in a case where the in-plane standard deviation and the thickness standard deviation of the area ratio of the piezoelectric particles are set within the above-described ranges, can be further improved, the average value of the area ratio of the piezoelectric particles in 100 parts is preferably 40 to 90, more preferably 50 to 80, and still more preferably 60 to 75.

In addition, from the viewpoint that the sound pressure, in a case where the in-plane standard deviation and the thickness standard deviation of the area ratio of the piezoelectric particles are set within the above-described ranges, can be further improved, a particle diameter of the piezoelectric particles is preferably 0.5 µm to 30 µm, more preferably 1 µm to 20 µm, and still more preferably 2 µm to 10 µm.

In addition, from the viewpoint that the sound pressure, in a case where the in-plane standard deviation and the thickness standard deviation of the area ratio of the piezoelectric particles are set within the above-described ranges, can be further improved, a thickness of the piezoelectric layer is preferably 1 µm to 200 µm, more preferably 5 µm to 150 µm, and still more preferably 10 µm to 100 µm.

Hereinafter, constituent elements of the piezoelectric film according to the embodiment of the present invention will be described in more detail.

### <Piezoelectric layer>

In the present invention, the piezoelectric layer 20 is a polymer-based piezoelectric composite material containing piezoelectric particles 36 in the matrix 34 containing a polymer material, as conceptually shown in Fig. 1.

As a material of the matrix 34 (serving as a matrix and a binder) of the polymer-based piezoelectric composite material constituting the piezoelectric layer 20, it is preferable to use a polymer material having viscoelasticity at normal temperature. In the present specification, the "normal temperature" indicates a temperature range of approximately 0°C to 50°C.

Here, it is preferable that the polymer-based piezoelectric composite material (piezoelectric layer 20) satisfies the following requirements.

### (i) Flexibility

For example, in a case of being gripped in a state of being loosely bent with a sense of document such as a newspaper and a magazine as a portable device, the polymer-based piezoelectric composite material is continuously subjected to large bending deformation from the outside at a comparatively slow vibration of less than or equal to a few Hz. At this time, in a case where the polymer-based piezoelectric composite material is rigid, large bending stress is generated to that extent, and a crack is generated at an interface between the polymer matrix and the piezoelectric particles, which may lead to breakage. Accordingly, the polymer-based piezoelectric composite material is required to have suitable flexibility. In addition, in a case where strain energy is diffused into the outside as heat, the stress can be relaxed. Therefore, the polymer-based piezoelectric composite material is required to have a suitably large loss tangent.

### (ii) Acoustic quality

In a speaker, the piezoelectric particles vibrate at a frequency of an audio band of 20 Hz to 20 kHz, and vibration energy causes the entire polymer-based piezoelectric composite material (piezoelectric film) to vibrate integrally so that sound is reproduced. Therefore, in order to increase transmission efficiency of the vibration energy, the polymer-based piezoelectric composite material is required to have appropriate rigidity. In addition, in a case where frequency characteristics of the speaker are smooth, an amount of a change in acoustic quality decreases in a case where the lowest resonance frequency is changed in association with a change in curvature of the speaker. Therefore, the polymer-based piezoelectric composite material is required to have a suitably large loss tangent.

Accordingly, the polymer-based piezoelectric composite material is required to exhibit a behavior of being rigid with respect to a vibration of 20 Hz to 20 kHz and being flexible with respect to a vibration of less than or equal to a few Hz. In addition, the loss tangent of the polymer-based piezoelectric composite material is required to be suitably large with respect to the vibration of all frequencies of 20 kHz or less.

Furthermore, in a case where the piezoelectric film is used as a piezoelectric element (exciter), it is preferable that the spring constant can be easily adjusted by lamination in accordance with the rigidity (hardness, stiffness, and spring constant) of the mating material (vibration plate) to be attached. In that regard, as a bonding layer is thinner, the energy efficiency can be increased.

In general, a polymer solid has a viscoelasticity relaxing mechanism, and a molecular movement with a large scale is observed as a decrease (relief) in a storage elastic modulus (Young's modulus) or a maximal value (absorption) in a loss elastic modulus along with an increase in temperature or a decrease in frequency. Among these, the relaxation due to a microbrown movement of a molecular chain in an amorphous region is referred to as main dispersion, and an extremely large relaxing phenomenon is observed. A temperature at which this main dispersion occurs is a glass transition point (Tg), and the viscoelasticity relaxing mechanism is most remarkably observed.

In the polymer-based piezoelectric composite material (piezoelectric layer 20), the polymer-based piezoelectric composite material exhibiting a behavior of being rigid with respect to the vibration of 20 Hz to 20 kHz and being flexible with respect to the slow vibration of less than or equal to a few Hz is achieved by using, as a matrix, a polymer material having a glass transition point at normal temperature, that is, a polymer material having viscoelasticity at normal temperature. In particular, from the viewpoint that such a behavior is suitably exhibited, it is preferable that a polymer material in which the glass transition point at a frequency of 1 Hz is at normal temperature, that is, in a range of 0°C to 50°C is used for a matrix of the polymer-based piezoelectric composite material.

As the polymer material having a viscoelasticity at normal temperature, various known materials can be used. It is preferable that a polymer material in which the maximal value of a loss tangent Tanδ at a frequency of 1 Hz according to a dynamic viscoelasticity test at normal temperature, that is, in a range of 0°C to 50°C is 0.5 or more is used as the polymer material.

In this manner, in a case where the polymer-based piezoelectric composite material is slowly bent due to an external force, stress concentration on the interface between the polymer matrix and the piezoelectric particles at the maximum bending moment portion is relaxed, and thus high flexibility can be expected.

In the polymer material having a viscoelasticity at normal temperature, it is preferable that a storage elastic modulus (E') at a frequency of 1 Hz according to the dynamic viscoelasticity measurement is 100 MPa or more at 0°C and 10 MPa or less at 50°C.

In this manner, a bending moment generated in a case where the polymer-based piezoelectric composite material is slowly bent due to the external force can be reduced, and at the same time, the polymer-based piezoelectric composite material can exhibit a behavior of being rigid with respect to an acoustic vibration of 20 Hz to 20 kHz.

In addition, it is more suitable that a relative permittivity of the polymer material having a viscoelasticity at normal temperature is 10 or more at 25°C. Accordingly, in a case where a voltage is applied to the polymer-based piezoelectric composite material, a higher electric field is applied to the piezoelectric particles in the matrix, and thus a large deformation amount can be expected.

However, in consideration of ensuring favorable moisture resistance and the like, it is suitable that the relative permittivity of the polymer material is 10 or less at 25°C.

Examples of the polymer material having a viscoelasticity at normal temperature and satisfying such conditions include cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, and polybutyl methacrylate. In addition, as these polymer materials, a commercially available product such as Hybrar 5127 (manufactured by Kuraray Co., Ltd.) can also be suitably used. Among these, as the polymer material, a material having a cyanoethyl group is preferably used, and cyanoethylated PVA is particularly preferably used.

Among these, as the polymer material having viscoelasticity at normal temperature, it is preferable to use a polymer material having a cyanoethyl group and particularly preferable to use cyanoethylated PVA. That is, in the present invention, as the matrix 34 of the piezoelectric layer 20, it is preferable to use a polymer material containing a cyanoethyl group and particularly preferable to use cyanoethylated PVA.

In the following description, the above-described polymer materials typified by cyanoethylated PVA will also be collectively referred to as "polymer material having viscoelasticity at normal temperature".

These polymer materials having viscoelasticity at normal temperature may be used alone or in combination (mixture) of two or more kinds thereof.

The matrix 34 using such a polymer material having a viscoelasticity at normal temperature may use a plurality of polymer materials in combination as necessary.

That is, in order to control dielectric properties, mechanical properties, or the like, other dielectric polymer materials may be added to the matrix 34 as necessary, in addition to the viscoelastic material such as cyanoethylated PVA.

Examples of the dielectric polymer material which can be added thereto include fluorine-based polymers such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, and a polyvinylidene fluoride-tetrafluoroethylene copolymer; polymers having a cyano group or a cyanoethyl group, such as a vinylidene cyanide-vinyl acetate copolymer, cyanoethyl cellulose, cyanoethyl hydroxysaccharose, cyanoethyl hydroxycellulose, cyanoethyl hydroxypullulan, cyanoethyl methacrylate, cyanoethyl acrylate, cyanoethyl hydroxyethyl cellulose, cyanoethyl amylose, cyanoethyl hydroxypropyl cellulose, cyanoethyl dihydroxypropyl cellulose, cyanoethyl hydroxypropyl amylose, cyanoethyl polyacrylamide, cyanoethyl polyacrylate, cyanoethyl pullulan, cyanoethyl polyhydroxymethylene, cyanoethyl glycidol pullulan, cyanoethyl saccharose, and cyanoethyl sorbitol; and synthetic rubber such as nitrile rubber and chloroprene rubber.

Among these, a polymer material having a cyanoethyl group is suitably used.

**In** addition, in the matrix 34 of the piezoelectric layer 20, the number of these dielectric polymer materials is not limited to one, and a plurality of kinds of dielectric polymer materials may be added.

**In** addition, for the purpose of controlling the glass transition point Tg, a thermoplastic resin such as a vinyl chloride resin, polyethylene, polystyrene, a methacrylic resin, polybutene, and isobutylene, and a thermosetting resin such as a phenol resin, a urea resin, a melamine resin, an alkyd resin, and mica may be added to the matrix 34 in addition to the dielectric polymer material.

Furthermore, for the purpose of improving pressure-sensitive adhesiveness, a viscosity imparting agent such as rosin ester, rosin, terpene, terpene phenol, and a petroleum resin may be added.

**In** the matrix 34 of the piezoelectric layer 20, an addition amount of materials to be added, other than the polymer material having viscoelasticity, such as cyanoethylated PVA, is not particularly limited, but is preferably set to 30% by mass or less in terms of the proportion of the materials in the matrix 34.

In this manner, characteristics of the polymer material to be added can be exhibited without impairing the viscoelasticity relaxing mechanism in the matrix 34, so that preferred results such as an increase in permittivity, improvement of heat resistance, and improvement of adhesiveness between the piezoelectric particles 36 and the electrode layer can be obtained.

The piezoelectric layer 20 is a layer consisting of the polymer-based piezoelectric composite material containing the piezoelectric particles 36 in the matrix 34. The piezoelectric particles 36 are dispersed in the matrix 34. It is preferable that the piezoelectric particles 36 are dispersed uniformly (substantially uniform) in the matrix 34.

The piezoelectric particles 36 consist of ceramic particles having a perovskite type or wurtzite type crystal structure.

Examples of the ceramic particles constituting the piezoelectric particles 36 include lead zirconate titanate (PZT), lead lanthanum zirconate titanate (PLZT), barium titanate (BaTiO₃), zinc oxide (ZnO), and a solid solution (BFBT) of barium titanate and bismuth ferrite (BiFe₃).

A particle diameter of the piezoelectric particles 36 is not limited, and may be appropriately selected depending on the size of the piezoelectric film 10 and the applications of the piezoelectric element 50.

By setting the particle diameter of the piezoelectric particles 36 to be within the above-described range, preferred results in terms of achieving both excellent piezoelectric characteristics and flexibility of the piezoelectric film 10 can be obtained.

In the piezoelectric film 10, a ratio between an amount of the matrix 34 and an amount of the piezoelectric particles 36 in the piezoelectric layer 20 is not limited, and may be appropriately set according to the size and the thickness of the piezoelectric film 10 in the plane direction, the applications of the piezoelectric film 10, the characteristics required for the piezoelectric film 10, and the like.

A volume fraction of the piezoelectric particles 36 in the piezoelectric layer 20 is preferably 30% to 80%, more preferably 50% or more, and still more preferably 50% to 80%.

By setting the ratio between the amount of the matrix 34 and the amount of the piezoelectric particles 36 to be within the above-described range, preferred results in terms of achieving both excellent piezoelectric characteristics and flexibility can be obtained.

In the piezoelectric film 10, a thickness of the piezoelectric layer 20 is not particularly limited and may be appropriately set according to the applications of the piezoelectric film 10, the number of lamination of the piezoelectric film in the piezoelectric element 50, the characteristics required for the piezoelectric film 10, and the like.

It is advantageous that the thickness of the piezoelectric layer 20 increases large in terms of stiffness such as the strength of rigidity of a so-called sheet-like material, but the voltage (potential difference) required to stretch and contract the piezoelectric film 10 increases by the same amount.

The thickness of the piezoelectric layer 20 is as described above.

By setting the thickness of the piezoelectric layer 20 to be within the above-described ranges, preferred results in terms of achieving both ensuring of the rigidity and moderate elasticity can be obtained.

In addition, it is preferable that the piezoelectric layer 20 is subjected to a polarization treatment (poling) in the thickness direction.

As shown in Fig. 1, the piezoelectric film 10 has a configuration in which the first electrode layer 24 is provided on one surface of the piezoelectric layer 20, the first protective layer 28 is provided thereon, the second electrode layer 26 is provided on the other surface of the piezoelectric layer 20, and the second protective layer 30 is provided thereon. Here, the first electrode layer 24 and the second electrode layer 26 form an electrode pair.

That is, the piezoelectric film 10 has a configuration in which both surfaces of the piezoelectric layer 20 are sandwiched between the electrode pair, that is, the first electrode layer 24 and the second electrode layer 26, and this laminate is sandwiched between the first protective layer 28 and the second protective layer 30.

In this way, in the piezoelectric film 10, a region sandwiched between the first electrode layer 24 and the second electrode layer 26 stretches and contracts according to an applied voltage.

The piezoelectric film 10 in the present invention may include, in addition to those layers, for example, a bonding layer for bonding the electrode layer and the piezoelectric layer 20 to each other, and a bonding layer for bonding the electrode layer and the protective layer to each other.

The bonding agent may be an adhesive or a pressure-sensitive adhesive. In addition, the same material as the polymer material obtained by removing the piezoelectric particles 36 from the piezoelectric layer 20, that is, the matrix 34 can also be suitably used as the bonding agent. The bonding layer may be provided on both the first electrode layer 24 side and the second electrode layer 26 side, or may be provided only on one of the first electrode layer 24 side or the second electrode layer 26 side.

The first protective layer 28 and the second protective layer 30 in the piezoelectric film 10 have a function of coating the first electrode layer 24 and the second electrode layer 26 and imparting moderate rigidity and mechanical strength to the piezoelectric layer 20. That is, the piezoelectric layer 20 consisting of the matrix 34 and the piezoelectric particles 36 in the piezoelectric film 10 exhibits extremely excellent flexibility under bending deformation at a slow vibration, but may have insufficient rigidity or mechanical strength depending on the applications. As a compensation for this, the piezoelectric film 10 is provided with the first protective layer 28 and the second protective layer 30.

The first protective layer 28 and the second protective layer 30 are not limited and various sheet-like materials can be used, and suitable examples thereof include various resin films.

Among these, from the viewpoint of excellent mechanical characteristics and heat resistance, a resin film consisting of polyethylene terephthalate (PET), polypropylene (PP), polystyrene (PS), polycarbonate (PC), polyphenylene sulfite (PPS), polymethylmethacrylate (PMMA), polyetherimide (PEI), polyimide (PI), polyethylene naphthalate (PEN), triacetyl cellulose (TAC), a cyclic olefin-based resin, and the like is suitably used.

Thicknesses of the first protective layer 28 and the second protective layer 30 are not limited. In addition, the thicknesses of the first protective layer 28 and the second protective layer 30 are essentially the same as each other, but may be different from each other.

Here, in a case where the rigidity of the first protective layer 28 and the second protective layer 30 is extremely high, not only is the stretch and contraction of the piezoelectric layer 20 constrained, but also the flexibility is impaired. Therefore, it is advantageous that the thicknesses of the first protective layer 28 and the second protective layer 30 decrease except for the case where the mechanical strength or favorable handleability as a sheet-like material is required.

In a case where the thicknesses of the first protective layer 28 and the second protective layer 30 in the piezoelectric film 10 are two times or less the thickness of the piezoelectric layer 20, preferred results in terms of achieving both ensuring of the rigidity and moderate elasticity can be obtained.

For example, in a case where the thickness of the piezoelectric layer 20 is 50 µm and the first protective layer 28 and the second protective layer 30 consist of PET, the thicknesses of the first protective layer 28 and the second protective layer 30 are preferably 100 µm or less, more preferably 50 µm or less, and still more preferably 25 µm or less.

In the piezoelectric film 10, the first electrode layer 24 is formed between the piezoelectric layer 20 and the first protective layer 28, and the second electrode layer 26 is formed between the piezoelectric layer 20 and the second protective layer 30, respectively. The first electrode layer 24 and the second electrode layer 26 are provided to apply a voltage to the piezoelectric layer 20 (piezoelectric film 10).

In the present invention, a material for forming the first electrode layer 24 and the second electrode layer 26 is not limited, and various conductors can be used. Specific examples thereof include metals such as carbon, palladium, iron, tin, aluminum, nickel, platinum, gold, silver, copper, titanium, chromium, and molybdenum, alloys thereof, laminates and composites of these metals and alloys, and indium tin oxide. Specific examples thereof also include conductive polymers such as polyethylene dioxythiophene-polystyrene sulfonic acid (PEDOT/PPS). Among these, copper, aluminum, gold, silver, platinum, or indium tin oxide is suitable as the first electrode layer 24 and the second electrode layer 26. Among these, from the viewpoint of the conductivity, the cost, and the flexibility, copper is more preferable.

In addition, a method of forming the first electrode layer 24 and the second electrode layer 26 is not limited, and various known methods, for example, a vapor-phase deposition method (a vacuum film forming method) such as vacuum vapor deposition or sputtering, a film forming method using plating, and a method of bonding a foil formed of the materials described above can be used.

Among these, particularly from the reason that the flexibility of the piezoelectric film 10 can be ensured, a thin film made of copper, aluminum, or the like, which is formed by vacuum vapor deposition, is suitably used as the first electrode layer 24 and the second electrode layer 26. Among these, a thin film made of copper, which is formed by vacuum vapor deposition, is particularly suitably used.

Thicknesses of the first electrode layer 24 and the second electrode layer 26 are not limited. In addition, the thicknesses of the first electrode layer 24 and the second electrode layer 26 are essentially the same as each other, but may be different from each other.

Here, same as the first protective layer 28 and the second protective layer 30 described above, in a case where the rigidity of the first electrode layer 24 and the second electrode layer 26 is extremely high, not only the stretch and contraction of the piezoelectric layer 20 is constrained, but also the flexibility is impaired. Therefore, it is advantageous that the thicknesses of the first electrode layer 24 and the second electrode layer 26 decrease in a case where electric resistance is not extremely high.

In the piezoelectric film 10, from the viewpoint that the flexibility is not considerably impaired, it is suitable that a product of the thickness and the Young's modulus of the first electrode layer 24 and the second electrode layer 26 is less than a product of the thickness and the Young's modulus of the first protective layer 28 and the second protective layer 30.

For example, in a combination in which the first protective layer 28 and the second protective layer 30 consist of PET (Young's modulus: approximately 6.2 GPa) and the first electrode layer 24 and the second electrode layer 26 consist of copper (Young's modulus: approximately 130 GPa), in a case where the thicknesses of the first protective layer 28 and the second protective layer 30 are assumed to be 25 µm, the thicknesses of the first electrode layer 24 and the second electrode layer 26 are preferably 1.2 µm or less, more preferably 0.3 µm or less, and still more preferably 0.1 µm or less.

As described above, the piezoelectric film 10 has a configuration in which the piezoelectric layer 20 obtained by dispersing the piezoelectric particles 36 in the matrix 34 containing the polymer material is sandwiched between the first electrode layer 24 and the second electrode layer 26, and this laminate is sandwiched between the first protective layer 28 and the second protective layer 30.

In such the piezoelectric film 10, it is preferable that the maximal value of the loss tangent (Tanδ) at a frequency of 1 Hz according to the dynamic viscoelasticity measurement is present at normal temperature, and it is more preferable that the maximal value at which the loss tangent is 0.1 or more is present at normal temperature.

In this manner, even in a case where the piezoelectric film 10 is subjected to large bending deformation at a relatively slow vibration of less than or equal to a few Hz from the outside, since the strain energy can be effectively diffused to the outside as heat, occurrence of cracks at the interface between the polymer matrix and the piezoelectric particles can be prevented.

In the piezoelectric film 10, it is preferable that the storage elastic modulus (E') at a frequency of 1 Hz according to the dynamic viscoelasticity measurement is 10 to 30 GPa at 0°C and 1 to 10 GPa at 50°C. The same applies to the conditions for the piezoelectric layer 20.

In such a manner, the piezoelectric film 10 can have large frequency dispersion in the storage elastic modulus (E') at normal temperature. That is, the piezoelectric film 10 can exhibit a behavior of being rigid with respect to the vibration of 20 Hz to 20 kHz and being flexible with respect to the vibration of less than or equal to a few Hz.

In addition, in the piezoelectric film 10, it is preferable that a product of the thickness and the storage elastic modulus (E') at a frequency of 1 Hz according to the dynamic viscoelasticity measurement is 1.0 × 10⁵ to 2.0 × 10⁶ N/m at 0°C and 1.0 × 10⁵ to 1.0 × 10⁶ N/m at 50°C. The same applies to the conditions for the piezoelectric layer 20.

In this manner, the piezoelectric film 10 can have moderate rigidity and mechanical strength within a range not impairing the flexibility and the acoustic characteristics.

Furthermore, in the piezoelectric film 10, it is preferable that the loss tangent (Tanδ) at a frequency of 1 kHz at 25°C is 0.05 or more in a master curve obtained from the dynamic viscoelasticity measurement. The same applies to the conditions for the piezoelectric layer 20.

In this manner, the frequency characteristics of the speaker including the piezoelectric film 10 are smooth, so that an amount of change in acoustic quality in a case where the lowest resonance frequency f₀ is changed according to a change in curvature of the speaker can be decreased.

In addition, in the present invention, the storage elastic modulus (Young's modulus) and the loss tangent of the piezoelectric film 10, the piezoelectric layer 20, and the like may be measured by a known method. As an example, the measurement may be performed using a dynamic viscoelasticity measuring device DMS6100 (manufactured by SII Nanotechnology Inc.).

Examples of measurement conditions include each of conditions with a measurement frequency of 0.1 Hz to 20 Hz (0.1 Hz, 0.2 Hz, 0.5 Hz, 1 Hz, 2 Hz, 5 Hz, 10 Hz, and 20 Hz), a measurement temperature of -50°C to 150°C, a temperature rising rate of 2°C/min (in a nitrogen atmosphere), a sample size of 40 mm × 10 mm (including the clamped region), and a chuck-to-chuck distance of 20 mm.

A power supply that applies a driving voltage for stretching and contracting the piezoelectric film 10, that is, the power supply that supplies driving power is connected to the first electrode layer 24 and the second electrode layer 26 of the piezoelectric film 10.

The power supply is not limited, and may be a direct-current power supply or an alternating-current power supply. In addition, as the driving voltage, a driving voltage capable of suitably driving piezoelectric films 10 may be appropriately set in accordance with the thickness, forming material, and the like of the piezoelectric layer 20 in the piezoelectric film 10.

A method of leading out electrodes from the first electrode layer 24 and the second electrode layer 26 is not limited, and various known methods can be used.

Examples thereof include a method of connecting a conductor such as a copper foil to the first electrode layer 24 and the second electrode layer 26 and leading out the electrodes to the outside, and a method of forming through-holes in the first protective layer 28 and the second protective layer 30 with a laser or the like, filling the through-holes with a conductive material, and leading out the electrodes to the outside.

Examples of a suitable method of leading out the electrodes include the method described in JP2014-209724A and the method described in JP2016-015354A.

Here, as described above, the piezoelectric layer 20 contains the piezoelectric particles 36 in the matrix 34. In addition, the first electrode layer 24 and the second electrode layer 26 are provided with the piezoelectric layer 20 sandwiched therebetween in the thickness direction.

In a case where a voltage is applied to the first electrode layer 24 and the second electrode layer 26 of the piezoelectric film 10 including such the piezoelectric layer 20, the piezoelectric particles 36 stretch and contract in the polarization direction according to the applied voltage. As a result, the piezoelectric film 10 (piezoelectric layer 20) contracts in the thickness direction. At the same time, the piezoelectric film 10 stretches and contracts in the in-plane direction due to a Poisson's ratio. A degree of stretch and contraction is approximately 0.01% to 0.1%.

As described above, the thickness of the piezoelectric layer 20 is preferably approximately 10 to 300 µm.Accordingly, the degree of stretch and contraction in the thickness direction is as extremely small as approximately 0.3 µm at the maximum.

On the contrary, the piezoelectric film 10, that is, the piezoelectric layer 20, has a size much larger than the thickness in a plane direction. Therefore, for example, in a case where the length of the piezoelectric film 10 is 20 cm, the piezoelectric film 10 stretches and contracts by a maximum of approximately 0.2 mm in the plane direction by the application of a voltage.

Further, in a case where a pressure is applied to the piezoelectric film 10, electric power is generated by the action of the piezoelectric particles 36.

By utilizing this, the piezoelectric film 10 can be used for various applications such as a speaker, a microphone, and a pressure-sensitive sensor.

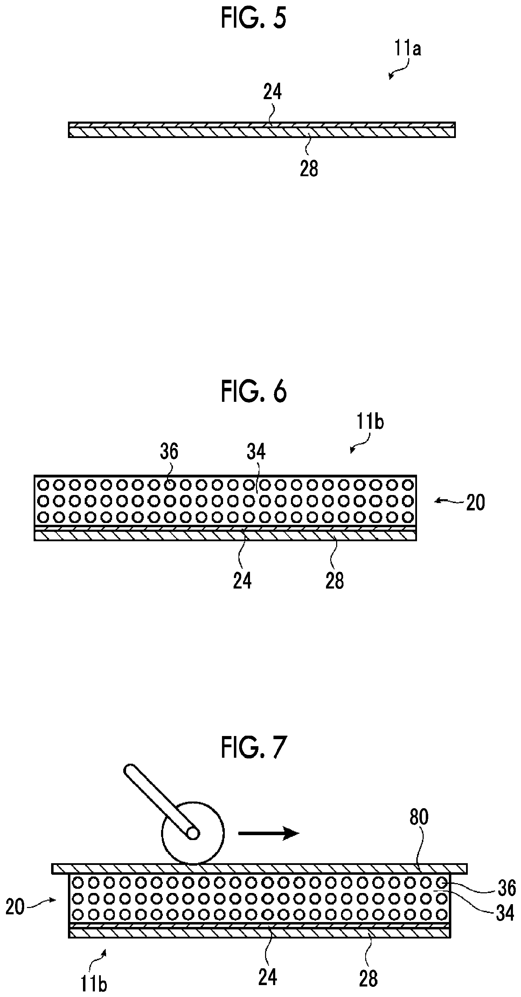

Next, an example of the method of producing the piezoelectric film 10 will be described with reference to Figs. 5 to 8.

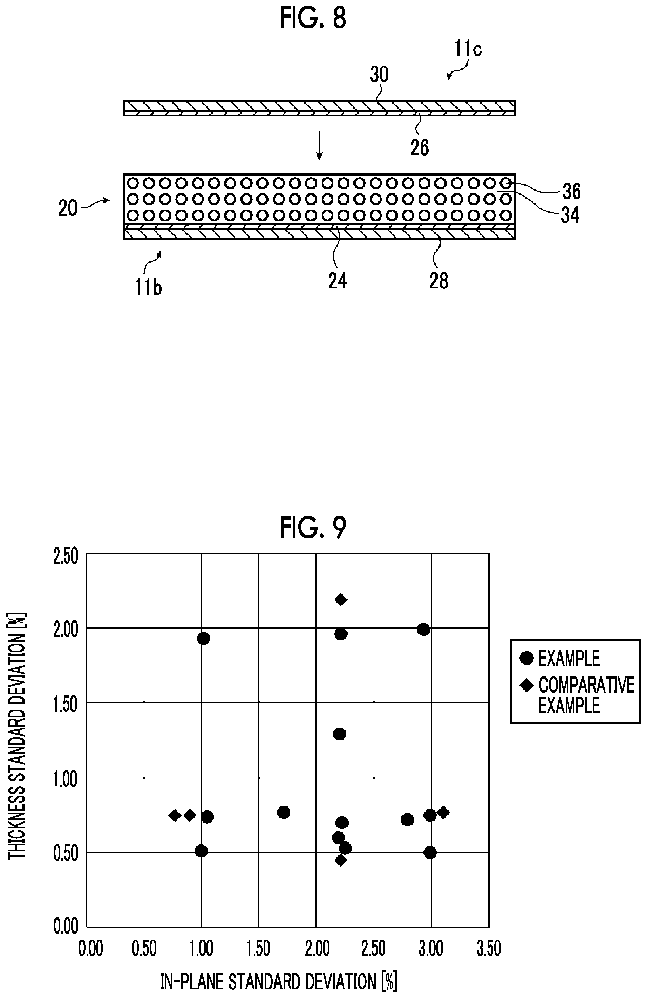

First, as shown in Fig. 5, a sheet-like material 11a in which the first electrode layer 24 has been formed on a surface of the first protective layer 28 is prepared. Furthermore, as conceptually shown in Fig. 8, a sheet-like material 11c in which the second electrode layer 26 has been formed on a surface of the second protective layer 30 is prepared.

The sheet-like material 11a may be produced by forming a copper thin film or the like as the first electrode layer 24 on the surface of the first protective layer 28 using vacuum vapor deposition, sputtering, plating, or the like. Similarly, the sheet-like material 11c may be produced by forming a copper thin film or the like as the second electrode layer 26 on the surface of the second protective layer 30 using vacuum vapor deposition, sputtering, plating, or the like.

Alternatively, a commercially available sheet-like material in which a copper thin film or the like is formed on a protective layer may be used as the sheet-like material 11a and/or the sheet-like material 11c.

The sheet-like material 11a and the sheet-like material 11c may be exactly the same or different from each other.

In a case where the protective layer is extremely thin and thus the handleability is degraded, the protective layer with a separator (temporary support) may be used as necessary. PET having a thickness of 25 to 100 µm, or the like can be used as the separator. The separator may be removed after thermal compression bonding of the electrode layer and the protective layer.

Next, as shown in Fig. 6, the first electrode layer 24 of the sheet-like material 11a is coated with a coating material (coating composition) forming the piezoelectric layer 20, and the coating material is cured to form the piezoelectric layer 20. In this manner, a laminate 11b in which the sheet-like material 11a and the piezoelectric layer 20 are laminated is produced.

The piezoelectric layer 20 can be formed by various methods depending on the forming material of the piezoelectric layer 20.

As an example, first, the coating material is prepared by dissolving the above-described polymer material such as cyanoethylated PVA in an organic solvent, adding the piezoelectric particles 36 such as PZT particles thereto, and stirring the solution.

The organic solvent is not limited, and various organic solvents such as dimethylformamide (DMF), methyl ethyl ketone (MEK), and cyclohexanone can be used.

In a case where the sheet-like material 11a is prepared and the coating material is prepared, the coating material is cast (applied) onto the sheet-like material 11a, and the organic solvent is evaporated and dried. In this manner, as shown in Fig. 15, the laminate 11b in which the first electrode layer 24 is provided on the first protective layer 28 and the piezoelectric layer 20 is laminated on the first electrode layer 24 is produced.

A casting method of the coating material is not limited, and all known methods (coating devices) such as a bar coater, a slide coater, and a doctor knife can be used.

Alternatively, in a case where the polymer material is a material which can be heated and melted, the laminate 11b as shown in Fig. 15 may be produced by heating and melting the polymer material to produce a melt obtained by adding the piezoelectric particles 36 to the melted material, extruding the melt on the sheet-like material 11a shown in Fig. 14 in a sheet shape by carrying out extrusion molding or the like, and cooling the laminate.

As described above, in the piezoelectric layer 20 a polymer piezoelectric material such as polyvinylidene difluoride (PVDF) may be added to the matrix 34, in addition to the polymer material having viscoelasticity at normal temperature.

In a case where the polymer piezoelectric material is added to the matrix 34, the polymer piezoelectric material to be added to the above-described coating material may be dissolved. Alternatively, the polymer piezoelectric material to be added may be added to the heated and melted polymer material having viscoelasticity at normal temperature so that the polymer piezoelectric material is heated and melted.

Here, in the present invention, in order to adjust the in-plane standard deviation and the thickness standard deviation of the area ratio of the piezoelectric particles to the above-described range, it is preferable to include cyclohexanone, DMF (N,N-dimethylformamide), and the like as the organic solvent contained in the coating material for forming the piezoelectric layer 20. Since cyclohexanone and the like have a higher boiling point and are less likely to volatilize than MEK, a large number of voids are likely to be generated in the coating film in a case where the organic solvent is evaporated and dried after the coating material is applied. In a case where a calender treatment described later is performed on a coating film in which a large number of voids are generated, the voids are crushed. Therefore, an area ratio of the piezoelectric particles in the thickness direction at a position in which the voids are present in the in-plane direction is relatively higher than an area ratio of the piezoelectric particles in the thickness direction at a position in which the voids are not present in the in-plane direction. As a result, as shown in Fig. 2, the presence state of the piezoelectric particles can be set to have a certain degree of unevenness in the in-plane direction, and the in-plane standard deviation of the area ratio of the piezoelectric particles can be set to a high value of 1 or more.

From the viewpoint of forming voids in the coating film as described above, a proportion of the cyclohexanone in a total solvent in the coating material is preferably 82% by mass to 97% by mass, more preferably 85% by mass to 95% by mass, and still more preferably 88% by mass to 93% by mass.

In order to adjust the in-plane standard deviation and the thickness standard deviation of the area ratio of the piezoelectric particles to the above-described ranges, it is preferable to perform coating a plurality of times during the coating with the coating material for forming the piezoelectric layer 20. By preparing coating materials having different contents of the piezoelectric particles and applying the coating materials a plurality of times while changing a type of the coating material to be applied, a coating film is formed. Therefore, the presence state of the piezoelectric particles can be set to be a state having a certain degree of unevenness in the thickness direction, and the thickness standard deviation of the area ratio of the piezoelectric particles in the thickness direction can be adjusted.

After forming the piezoelectric layer 20 (coating film), a calender treatment may be performed as necessary. The calender treatment may be performed once or a plurality of times.

As is well known, the calender treatment is a treatment in which the surface to be treated is pressed while being heated by a heating press, a heating roller, or the like to flatten the surface. For example, as shown in Fig. 7, a film 80 for a calender treatment is placed on the surface of the piezoelectric layer 20 (coating film), and the film 80 for a calender treatment is pressed from above with a roller. In this manner, as described above, the voids in the piezoelectric layer 20 (coating film) are crushed, and the presence state of the piezoelectric particles can be set to be a state having a certain degree of unevenness in the in-plane direction.

In the calender treatment, a pressing force is preferably 0.1 MPa to 10 MPa.

Next, the piezoelectric layer 20 of the laminate 11b including the first electrode layer 24 on the first protective layer 28 and including the piezoelectric layer 20 formed on the first electrode layer 24 is subjected to a polarization treatment (poling). The polarization treatment of the piezoelectric layer 20 may be performed before the calender treatment, but it is preferable that the polarization treatment is performed after the calender treatment.

A method of performing the polarization treatment on the piezoelectric layer 20 is not limited, and a known method can be used. For example, electric field poling in which a DC electric field is directly applied to a target to be subjected to the polarization treatment is exemplified. In a case of performing the electric field poling, the electric field poling treatment may be performed using the first electrode layer 24 and the second electrode layer 26 by forming the second electrode layer 26 before the polarization treatment.

In addition, in the piezoelectric film 10 according to the embodiment of the present invention, it is preferable that the polarization treatment is performed in the thickness direction instead of the plane direction of the piezoelectric layer 20.

Next, as shown in Fig. 8, the sheet-like material 11c which has been prepared in advance is laminated on the piezoelectric layer 20 side of the laminate 11b which has been subjected to the polarization treatment, such that the second electrode layer 26 faces the piezoelectric layer 20.

Furthermore, the piezoelectric film 10 as shown in Fig. 1 is produced by subjecting the laminate to a thermal compression bonding using a heating press device, a heating roller, or the like such that this laminate is sandwiched between the first protective layer 28 and the second protective layer 30, and bonding the laminate 11b on the sheet-like material 11c.

Alternatively, the piezoelectric film 10 may be produced by bonding and preferably further compression-bonding the laminate 11b and the sheet-like material 11c to each other using an adhesive. As the adhesive in this case, the same material as the matrix of the piezoelectric layer 20 can be used.

The piezoelectric film 10 may be produced using the cut sheet-like material 11a and the cut sheet-like material 11c, or may be produced by roll-to-roll.

The produced piezoelectric film may be cut into a desired shape according to various applications. In addition, a heating treatment may be performed after cutting.

The piezoelectric film 10 to be produced in the above-described manner is polarized in the thickness direction instead of the plane direction, and thus excellent piezoelectric characteristics are obtained even in a case where a stretching treatment is not performed after the polarization treatment. Therefore, the piezoelectric film 10 has no in-plane anisotropy as a piezoelectric characteristic, and stretches and contracts isotropically in all directions in the plane direction in a case where a driving voltage is applied.

As an example, the piezoelectric film 10 is used in various acoustic devices (audio equipment) such as speakers, microphones, and pickups used in musical instruments such as a guitar to generate (reproduce) sound through vibration in response to an electrical signal and to convert sound vibration into an electrical signal.

In addition, the piezoelectric film 10 can also be used in pressure-sensitive sensors, power generation elements, and the like in addition to the examples described above.

Alternatively, the piezoelectric film 10 can also be used as an exciter which vibrates an article and generates sound by being brought into contact with and attached to various articles.

In addition, the piezoelectric film 10 can be used by being integrated with a flexible display.

Examples of the flexible display include display devices such as an organic electroluminescence (organic light emitting diode (OLED)) display, a liquid crystal display, a micro light emitting diode (LED) display, and an inorganic electroluminescence display, and a projector screen.

In addition, the piezoelectric film according to the embodiment of the present invention can be used as a piezoelectric element by laminating a plurality of layers. The piezoelectric element is used as an exciter by being attached to a vibration plate.

The vibration plate may have flexibility that allows the vibration plate to be rolled up. In the present invention, the expression "having flexibility" is synonymous with having flexibility in the general interpretation, and indicates being capable of bending and being flexible, specifically, being capable of bending and stretching without causing breakage and damage.

The vibration plate is not limited, and various sheet-like materials (plate-like materials and films) can be used.

Examples thereof include resin films made of polyethylene terephthalate (PET), polypropylene (PP), polystyrene (PS), polycarbonate (PC), polyphenylene sulfide (PPS), polymethylmethacrylate (PMMA), and polyetherimide (PEI), polyimide (PI), polyethylene naphthalate (PEN), triacetyl cellulose (TAC), cyclic olefin-based resins, or the like, foamed plastic made of expanded polystyrene, expanded styrene, expanded polyethylene, or the like, veneer boards, cork boards, leathers such as cowhide, various kinds of paperboards such as carbon sheets and Japanese paper, various kinds of corrugated cardboard materials obtained by bonding, to one or both surfaces of a corrugated paperboard, other paperboards, and various kinds of metals such as stainless steel, aluminum, copper, and nickel, and a thin film metal consisting of various kinds of alloys. In addition, the vibration plate may be a composite material obtained by bonding a film-like material consisting of these materials.

In addition, display devices such as an organic electro-luminescence (organic light emitting diode (OLED)) display, a liquid crystal display, a micro light emitting diode (LED) display, and an inorganic electroluminescence display, and projector screens can also be suitably used as the vibration plate.

The piezoelectric element is used as a so-called exciter that exhibits piezoelectricity in response to an applied voltage to vibrate the vibration plate. The piezoelectric element and the vibration plate are bonded to each other by the bonding layer.

The piezoelectric element may have a configuration in which a plurality of layers of the piezoelectric film 10 are laminated by folding one rectangular long piezoelectric film 10 a plurality of times in one direction, or may have a configuration in which a plurality of sheets of the sheet-like piezoelectric film 10 are laminated.

In addition, in a case where the piezoelectric element has a configuration in which the piezoelectric film is folded back and laminated, it is preferable that a configuration is adopted, in which the piezoelectric film of an outermost layer has a protruding portion that protrudes outward in the plane direction from a laminated portion where the piezoelectric film is laminated, so that a connecting portion for connecting the first electrode layer 24, the second electrode layer 26, and the power supply is formed in the protruding portion. A method of connecting the electrode layer and wiring in the protruding portion is not limited, and various known methods can be used.

The piezoelectric element in which the long piezoelectric film is folded and laminated has the following advantages.

That is, in a case where a plurality of cut sheet-like piezoelectric films 10 are laminated, it is necessary to connect the first electrode layer 24 and the second electrode layer 26 to a driving power supply for each piezoelectric film. On the contrary, in the configuration in which the long piezoelectric film 10 is folded and laminated, only one sheet of the long piezoelectric film 10 can form the laminate. In addition, in the configuration in which the long piezoelectric film 10 is folded and laminated, only one power supply is required for applying the driving voltage, and the electrodes may be led out from the piezoelectric film 10 in one place.

Furthermore, in the configuration in which the long piezoelectric film 10 is folded and laminated, polarization directions of adjacent piezoelectric films are inevitably opposite to each other.

In the piezoelectric element, in a case of a configuration in which the plurality of piezoelectric films 10 are laminated, the piezoelectric films 10 are bonded to each other by the bonding layer. As the bonding layer for bonding the piezoelectric films 10, various known materials can be used as long as the adjacent piezoelectric films 10 can be bonded.

As the bonding layer, various known layers can be used as long as the vibration plate and the piezoelectric element or the piezoelectric films 10 can be bonded to each other.

Therefore, the bonding layer may be a layer formed of an adhesive which has fluidity in a case of bonding and then is to be a solid, a layer formed of a pressure-sensitive adhesive which is a gel-like (rubber-like) soft solid in a case of bonding and the gel-like state does not change thereafter, or a layer formed of a material having characteristics of both the adhesive and the pressure-sensitive adhesive. In addition, the adhesive (pressure-sensitive adhesive) may be any of a moisture-curing adhesive, a thermoplastic adhesive, or a thermosetting adhesive. In addition, a double-sided tape, a pressure-sensitive adhesive sheet, or the like may be used as the bonding layer.

The vibration plate is bonded to the piezoelectric element with the bonding layer. Therefore, the stretch and contraction of the piezoelectric element (piezoelectric film 10) causes the vibration plate to bend, and as a result, the vibration plate vibrates in the thickness direction.

The vibration plate generates a sound using the vibration in the thickness direction. That is, the vibration plate vibrates according to the magnitude of the voltage (driving voltage) applied to the piezoelectric film 10, and generates a sound according to the driving voltage applied to the piezoelectric film 10.

In addition, the sound pressure level can be improved by adjusting the mass of the piezoelectric element in accordance with a spring constant of the vibration plate. In a case where the mass of the piezoelectric element is large, the vibration plate is bent, and thus there is a possibility that the vibration of the vibration plate during driving is suppressed. On the other hand, in a case where the mass of the piezoelectric element is small, the resonance frequency is high, and the vibration of the vibration plate at a low frequency may be suppressed. In consideration of these points, it is preferable that the mass of the piezoelectric element is appropriately adjusted according to the spring constant of the vibration plate.

As described above, the piezoelectric film according to the embodiment of the present invention has been described in detail, but the present invention is not limited to the above-described examples and various improvements and changes may be made without departing from the scope of the present invention defined by the appended claims.

### Examples

Hereinafter, the present invention will be described in more detail with reference to specific examples of the present invention. The present invention is not limited to the examples, and the materials, the used amounts, the proportions, the treatment contents, the treatment procedures, and the like shown in the following examples can be appropriately changed within a range not departing from the scope of the present invention.

### [Example 1]

### <Production of piezoelectric film>

The piezoelectric film shown in Fig. 1 was produced by the method shown in Figs. 5 to 8 described above.

First, cyanoethylated PVA (CR-V, manufactured by Shin-Etsu Chemical Co., Ltd.) was dissolved in a mixed solvent of cyclohexanone and MEK at the following compositional ratio. Thereafter, PZT particles as piezoelectric particles were added to the solution at the following compositional ratio, and the solution was stirred using a propeller mixer (rotation speed: 2000 rpm), thereby preparing each of coating materials A to C for forming a piezoelectric layer.

### Coating material A

· PZT Particles: 300 parts by mass
· Cyanoethylated PVA: 15 parts by mass
· Cyclohexanone: 85 parts by mass
· MEK: 15 parts by mass

In all of the coating materials A to C, a proportion of cyclohexanone in a total solvent was set to 85% by mass. In addition, a concentration of the PZT particles in the solid content of the coating material A was set to 95% by mass, a concentration of the PZT particles in the solid content of the coating material B was set to 96% by mass, and a concentration of the PZT particles in the solid content of the coating material C was set to 94% by mass.

In the following Examples and Comparative Examples, the proportion of the cyclohexanone was appropriately changed. However, the coating material A was set as a coating material in which the concentration of the PZT particles was 95% by mass, the coating material B was set as a coating material in which the concentration of the PZT particles was 96% by mass, and the coating material C was set as a coating material in which the concentration of the PZT particles was 94% by mass.

Particles obtained by sintering commercially available PZT raw material powder at 1000°C to 1200°C and then crushing and classifying the sintered powder to have an average particle diameter of 5 µm were used as the PZT particles.

On the other hand, a sheet-like material (first laminate) obtained by performing vacuum vapor deposition on a copper thin film having a thickness of 0.3 µm was prepared on a PET film having a thickness of 4 µm. That is, in the present example, the first electrode layer and the second electrode layer were copper-deposited thin films having a thickness of 0.3 µm, and the first protective layer and the second protective layer were PET films having a thickness of 4 µm.

The coating material B and the coating material C for forming the piezoelectric layer, which had been prepared in advance, were alternately applied four times from the coating material B onto the first electrode layer (copper vapor deposition thin film), which is the sheet-like material, using a slide coater.

First, the first electrode layer (copper-deposited thin film) of the sheet-like material was coated with the coating material B for forming a piezoelectric layer, which was prepared in advance, using a slide coater. The coating material B was applied such that the film thickness of the coating film after being dried was 10 µm.

Next, the coating material C for forming the piezoelectric layer prepared in advance was applied onto a first coating film using a slide coater. The coating material C was applied such that the film thickness of the coating film after being dried was 10 µm.

Next, the coating material B for forming the piezoelectric layer prepared in advance was applied onto a second coating film using a slide coater. The coating material B was applied such that the film thickness of the coating film after being dried was 10 µm.

Further, the coating material C for forming the piezoelectric layer prepared in advance was applied onto a third coating film using a slide coater. The coating material C was applied such that the film thickness of the coating film after being dried was 10 µm.

Next, a material obtained by applying the coating material to the sheet-like material was heated and dried on a hot plate at 50°C to evaporate the organic solvent (cyclohexanone).

As described above, laminate in which the first electrode layer made of copper was provided on the first protective layer made of PET and the piezoelectric layer (polymer-based piezoelectric composite material layer) having a thickness of 40 µm was formed thereon was produced.

The produced piezoelectric layer was subjected to a calender treatment. A roller having a diameter of 100 mm was used. In addition, the pressing force was set to 1 MPa.

The produced piezoelectric layer was subjected to a polarization treatment in the thickness direction.

A sheet-like material obtained by vapor-depositing an identical thin film on the PET film was laminated on the piezoelectric laminate which had been subjected to the polarization treatment such that the second electrode layer (copper thin film side) faced the piezoelectric layer.

Next, a piezoelectric film as illustrated in Fig. 1 was prepared by performing thermal compression bonding on the laminate of the piezoelectric laminate and the sheet-like material at a temperature of 120°C using a laminator device, and bonding and adhering the piezoelectric layer and the second electrode layer to each other.

### <Measurement of in-plane standard deviation and thickness standard deviation>

A sample was cut out from the produced piezoelectric film, the sample was cut in the thickness direction by the above-described method, and the cross section was observed with a SEM (manufactured by Hitachi High-Technologies Corporation, SU8220). A SEM image was obtained by capturing 10 continuous visual fields at any position of the cross section with a SEM.

In the obtained SEM image, the thickness of the cross section of the piezoelectric layer is measured at intervals of 1 µm at 10 points, and the average value thereof was obtained. The thickness was 40 µm. 10 continuous regions in the SEM image were acquired with the same width as the average value of the obtained thicknesses as one region.

Each of the acquired 10 regions was divided into 10 parts in an in-plane direction as shown in Fig. 3, and an area ratio of the piezoelectric particles in one part 21 to a geometric area of the one part 21 was calculated in each of the total of 100 parts of the 10 regions. The standard deviation was calculated from the area ratio of the piezoelectric particles in the total of 100 parts, so that the in-plane standard deviation was obtained. The in-plane standard deviation was 1.02%. In addition, the average value of the area ratio of the piezoelectric particles of total of 100 parts was 64.93%.

In addition, as shown in Fig. 4, each of the acquired 10 regions was divided into 10 parts in the thickness direction, and the area ratio of the piezoelectric particles in one part 22 to the geometric area of the one part 22 was calculated in each of the total of 100 parts of the 10 regions. The standard deviation was calculated from the area ratio of the piezoelectric particles in the total of 100 parts, so that the thickness standard deviation was obtained. The thickness standard deviation was 1.93%.

### [Examples 2 to 13 and Comparative Examples 1 to 5]

A piezoelectric film was produced in the same manner as in Example 1, except that the ratio of cyclohexanone in the coating material, the type of the coating material, the number of coating times, and the thickness of the piezoelectric layer were changed as shown in Table 1.

The in-plane standard deviation and the thickness standard deviation in each of Examples and Comparative Examples were measured in the same manner as in Example 1.

### [Evaluation]

### <Sound pressure>

A rectangular test piece having a size of 210 × 300 mm (A4 size) was cut out from the produced piezoelectric film. The cut-out piezoelectric film was placed on a case having an opening portion with a size of 210 × 300 mm in which glass wool was stored, the peripheral portion was pressed by a frame to impart an appropriate tension and a curvature to the piezoelectric film, thereby preparing a piezoelectric speaker. A depth of the case was set to 9 mm, a density of glass wool was set to 32 kg/m³, and a thickness before assembly was set to 25 mm.

A 1 kHz sine wave was input to the prepared piezoelectric speaker as an input signal through a power amplifier, and the sound pressure was measured with a microphone placed at a distance of 60 cm from the center of the speaker. A voltage of the input signal was changed in proportion to the thickness of the piezoelectric layer.

The results are shown in Table 1. In addition, a graph in which the in-plane standard deviation and the thickness standard deviation of each of Examples and Comparative Examples are plotted is shown in Fig. 9.

**[Table 1]**

| | Condition for forming piezoelectric layer | | | | Piezoelectric layer | | | Evaluation |
|---|---|---|---|---|---|---|---|---|
| | Ratio of cyclohexanone [%] | Type of coating material | Number of coating times | Calender treatment | Thickness [µm] | In-plane standard deviation [%] | Thickness standard deviation [%] | Sound pressure [dB] |
| Example 1 | 85 | Coating material B, Coating material C | 4 times (in 10 µm increments) | Present | 40 | 1.02 | 1.93 | 80.5 |
| Example 2 | 90 | Coating material B, Coating material C | 4 times (in 10 µm increments) | Present | 40 | 2.21 | 1.96 | 80.3 |
| Example 3 | 95 | Coating material B, Coating material C | 4 times (in 10 µm increments) | Present | 40 | 2.93 | 1.99 | 80.2 |
| Example 4 | 90 | Coating material B, Coating material C | 2 times (in 20 µm increments) | Present | 40 | 2.20 | 1.29 | 83.5 |
| Example 5 | 85 | Coating material A | 1 time | Present | 40 | 1.05 | 0.74 | 80.1 |
| Example 6 | 87.5 | Coating material A | 1 time | Present | 40 | 1.72 | 0.77 | 83.7 |
| Example 7 | 90 | Coating material A | 1 time | Present | 40 | 2.22 | 0.70 | 86.4 |
| Example 8 | 92.5 | Coating material A | 1 time | Present | 40 | 2.79 | 0.72 | 84.0 |
| Example 9 | 95 | Coating material A | 1 time | Present | 40 | 2.99 | 0.75 | 80.2 |
| Example 10 | 90 | Coating material A | 1 time | Present | 20 | 2.19 | 0.60 | 83.7 |
| Example 11 | 85 | Coating material A | 1 time | Present | 10 | 1.00 | 0.51 | 81.0 |
| Example 12 | 90 | Coating material A | 1 time | Present | 10 | 2.25 | 0.53 | 80.5 |
| Example 13 | 95 | Coating material A | 1 time | Present | 10 | 2.99 | 0.50 | 80.1 |
| Comparative Example 1 | 80 | Coating material A | 1 time | Present | 40 | 0.77 | 0.75 | 78.0 |
| Comparative Example 2 | 90 | Coating material B, Coating material C | 6 times (in 10 µm increments) | Present | 60 | 2.21 | 2.19 | 79.3 |
| Comparative Example 3 | 82.5 | Coating material A | 1 time | Present | 40 | 0.90 | 0.75 | 79.5 |
| Comparative Example 4 | 97.5 | Coating material A | 1 time | Present | 40 | 3.10 | 0.77 | 79.0 |
| Comparative Example 5 | 90 | Coating material A | 1 time | Present | 7 | 2.21 | 0.45 | 79.2 |

From Table 1 and Fig. 9, it can be seen that the piezoelectric films of Examples in which the in-plane standard deviation and the thickness standard deviation satisfy the scope of the present invention have improved sound pressure as compared with those of Comparative Examples.

In addition, from a comparison between Examples 4, 6 to 8, and 10 and other Examples, it was found that the sound pressure was further improved by satisfying 1.7% ≤ in-plane standard deviation ≤ 2.8% and 0.6% ≤ thickness standard deviation ≤ 1.3%.

From the above, the effects of the present invention are clear.

The piezoelectric film according to the embodiment of the present invention is suitably used as the following, for example: as various sensors such as a sound wave sensor, an ultrasonic wave sensor, a pressure sensor, a tactile sensor, a strain sensor, and a vibration sensor (which are useful particularly for an infrastructure examination such as crack detection and a manufacturing site inspection such as foreign matter contamination detection); acoustic devices such as microphones, pickups, speakers, and exciters (as specific applications, noise cancellers (used for cars, trains, airplanes, robots, and the like), artificial voice bands, buzzers to prevent pests and beasts from invading, furniture, wallpaper, photo, helmet, goggles, headrest, signage, robot, and the like are exemplified); haptics used for application to automobiles, smartphones, smart watches, games, and the like; ultrasonic transducers such as ultrasound probe and hydrophones; actuators used for prevention of attachment of water droplets, transportation, agitation, dispersion, polishing, and the like; damping materials (dampers) used for containers, vehicles, buildings, sports equipment such as skis and rackets; and vibration power generator used for application to roads, floors, mattresses, chairs, shoes, tires, wheels, computer keyboards, and the like.

### Explanation of References

10: piezoelectric film
11a, 11c: sheet-like material
11b: laminate
20: piezoelectric layer
24: first electrode layer
26: second electrode layer
28: first protective layer
30: second protective layer
34: matrix
36: piezoelectric particle
80: film for calender treatment

## Claims

1. A piezoelectric film (10) comprising:
a piezoelectric layer (20) consisting of a polymer-based piezoelectric composite material which contains piezoelectric particles (36) in a matrix (34) containing a polymer material; and
two electrode layers (24, 26) provided on both surfaces of the piezoelectric layer,
**characterised in that**
in a case where a standard deviation in which a cross section of the piezoelectric layer in a thickness direction is observed with a scanning electron microscope, 10 regions each having the same width as a thickness of the cross section of the piezoelectric layer are continuously acquired, each of the regions is divided into 10 parts in an in-plane direction, and an area ratio of the piezoelectric particles in each of a total of 100 parts is calculated, is defined as an in-plane standard deviation, 1% ≤ in-plane standard deviation ≤ 3% is satisfied, and
in a case where a standard deviation in which each of the regions is divided into 10 parts in the thickness direction and an area ratio of the piezoelectric particles in each of a total of 100 parts is calculated, is defined as a thickness standard deviation, 0.5% ≤ thickness standard deviation ≤ 2% is satisfied.

2. The piezoelectric film according to claim 1,
wherein 1.7% ≤ in-plane standard deviation ≤ 2.8% and 0.6% ≤ thickness standard deviation ≤ 1.3% are satisfied.

3. The piezoelectric film according to claim 1 or 2,
wherein an average value of the area ratios of the piezoelectric particles in each of the total of 100 parts is 40% to 90%.

## Patentansprüche

1. Piezoelektrischer Film (10), umfassend:
eine piezoelektrische Schicht (20), die aus einem piezoelektrischen Verbundwerkstoff auf Polymerbasis, der piezoelektrische Partikel (36) in einer Matrix (34), die ein Polymermaterial enthält, enthält, besteht; und
zwei Elektrodenschichten (24, 26), die auf beiden Flächen der piezoelektrischen Schicht vorgesehen sind,
**dadurch gekennzeichnet, dass**
in einem Fall, in dem eine Standardabweichung, bei der ein Querschnitt der piezoelektrischen Schicht in einer Dickenrichtung mit einem Rasterelektronenmikroskop beobachtet wird, 10 Bereiche, die jeweils die gleiche Breite wie eine Dicke des Querschnitts der piezoelektrischen Schicht aufweisen, kontinuierlich erfasst werden, jeder der Bereiche in 10 Teile in einer In-Ebene-Richtung unterteilt wird und ein Flächenverhältnis der piezoelektrischen Partikel in jedem von insgesamt 100 Teilen berechnet wird, als eine In-Ebene-Standardabweichung definiert ist, 1 % ≤ In-Ebene-Standardabweichung ≤ 3 % erfüllt ist, und
in einem Fall, in dem eine Standardabweichung, bei der jeder der Bereiche in 10 Teile in der Dickenrichtung unterteilt wird und ein Flächenverhältnis der piezoelektrischen Partikel in jedem von insgesamt 100 Teilen berechnet wird, als eine Dickenstandardabweichung definiert ist, 0,5 % ≤ Dickenstandardabweichung ≤ 2 % erfüllt ist.

2. Piezoelektrischer Film nach Anspruch 1,
wobei 1,7 % ≤ In-Ebene-Standardabweichung ≤ 2,8 % und 0,6 % ≤ Dickenstandardabweichung ≤ 1,3 % erfüllt sind.

3. Piezoelektrischer Film nach Anspruch 1 oder 2,
wobei ein Durchschnittswert der Flächenverhältnisse der piezoelektrischen Partikel in jedem der insgesamt 100 Teile 40 % bis 90 % beträgt.

## Revendications

1. Film piézoélectrique (10) comprenant :
une couche piézoélectrique (20) constituée d'un matériau composite piézoélectrique à base de polymère qui contient des particules piézoélectriques (36) dans une matrice (34) contenant un matériau polymère ; et
deux couches d'électrode (24, 26) disposées sur les deux surfaces de la couche piézoélectrique,
**caractérisé en ce que**
dans un cas où un écart type, dans lequel une section transversale de la couche piézoélectrique dans une direction d'épaisseur est observée à l'aide d'un microscope électronique à balayage, 10 régions ayant chacune la même largeur qu'une épaisseur de la section transversale de la couche piézoélectrique sont acquises de manière continue, chacune des régions est divisée en 10 parties dans une direction dans le plan, et un rapport de surface des particules piézoélectriques dans chacune des 100 parties au total est calculé, est défini comme un écart type dans le plan, 1 % ≤ écart type dans le plan ≤ 3 % est satisfait, et
dans un cas où un écart type, dans lequel chacune des régions est divisée en 10 parties dans la direction d'épaisseur et un rapport de surface des particules piézoélectriques dans chacune des 100 parties au total est calculé, est défini comme un écart type d'épaisseur, 0,5 % ≤ écart type d'épaisseur ≤ 2 % est satisfait.

2. Film piézoélectrique selon la revendication 1,
dans lequel 1,7 % ≤ écart type dans le plan ≤ 2,8 % et 0,6 % ≤ écart type d'épaisseur ≤ 1,3 % sont satisfaits.

3. Film piézoélectrique selon la revendication 1 ou la revendication 2,
dans lequel une valeur moyenne des rapports de surface des particules piézoélectriques dans chacune des 100 parties au total est de 40 % à 90 %.
